# EUROPÄISCHE PATENTANMELDUNG

(11) **EP 1 109 207 A1**
(43) Veröffentlichungstag der Anmeldung: **20.06.2001**
(21) Anmeldenummer: 99811159.5
(22) Anmeldetag: 14.12.1999
(51) Int. Cl.: H01L 21/00, B25B 11/00

(54) **Ansaugvorrichtung zum Niederhalten eines Substrates**

(71) Anmelder: Esec SA, 6330 Cham (CH)
(72) Erfinder: Behler, Stefan, 6312 Steinhausen (CH); Enzler, August, 6331 Hünenberg (CH)
(74) Vertreter: Falk, Urs, Dr.

(57) **Zusammenfassung**

Eine Ansaugvorrichtung zum Niederhalten eines mit Halbleiterchips zu bestückenden oder bestückten Substrates (3) auf einer Auflagefläche (2) einer Platte (1) weist eine mit einer Vakuumquelle verbindbare Bohrung (5) zum Ansaugen des Substrates (3) auf. Die Platte (1) enthält eine gegen die Auflagefläche (2) offene Kavität (6). Die Kavität (6) weist ein flexibles Dichtungselement (7) auf zur Bildung eines abdichtenden Hohlraumes (9) zwischen dem Substrat (3) und der Bohrung (5). Sobald der abdichtende Hohlraum (9) gebildet ist, kann sich im Hohlraum (9) Vakuum ausbilden, so dass das Substrat (3) gegen die Auflagefläche (2) gesogen wird.

## Beschreibung

Die Erfindung betrifft eine Ansaugvorrichtung zum Niederhalten eines mit Halbleiterchips zu bestückenden oder bestückten Substrates der im Oberbegriff des Anspruchs 1 genannten Art.

Bei der Montage von Halbleiterchips auf einem Substrat mittels eines sogenannten Die Bonders wird das Substrat auf einer Auflagefläche taktweise um eine vorbestimmte Distanz transportiert, damit ein Halbleiterchip an der dafür vorgesehenen Stelle montiert werden kann. Damit das Substrat plan auf der Auflagefläche aufliegt, weist die Auflagefläche eine mit einer Vakuumquelle verbindbare Bohrung zum Ansaugen und Niederhalten des Substrates auf.

Einige Substrate, beispielsweise bereits mit Halbleiterchips bestückte BGA®'s (Ball Grid Array), die mit einem zweiten Halbleiterchip zu bestücken sind oder die zur Herstellung von Drahtverbindungen der Bondstation eines Wire Bonders zugeführt werden, sind unter Umständen derart stark gewölbt, dass das Ansaugen des Substrates nicht gelingt.

Der Erfindung liegt die Aufgabe zugrunde, eine Vorrichtung anzugeben, die auch stark gewölbte Substrate plan zur Auflagefläche niederhalten kann.

Die Erfindung besteht in den im Anspruch 1 angegebenen Merkmalen. Vorteilhafte Ausgestaltungen ergeben sich aus den abhängigen Ansprüchen.

Die Erfindung besteht darin, das Substrat wie gewohnt auf seiner Unterseite mit Vakuum zu beaufschlagen, dabei aber die Leckrate zu begrenzen, damit das Vakuum den Raum zwischen dem gewölbten Substrat und seiner Auflagefläche ausfüllen kann. Dazu wird mittels eines Dichtungselementes ein mehr oder weniger gut abdichtender Hohlraum gebildet, in dem das Vakuum erhalten bleibt. Die Druckdifferenz zwischen dem Druck auf der Oberseite des Substrates (Atmosphärendruck) und dem Druck auf der Unterseite (Vakuum) bewirkt dann, dass das Substrat flach gegen seine Unterlage gedrückt wird.

Nachfolgend werden Ausführungsbeispiele der Erfindung anhand der Zeichnung näher erläutert.

Es zeigen:
- Fig. 1A-C: Schnittzeichnungen einer Platte mit einer Ansaugvorrichtung für ein Substrat,
- Fig. 2A-C und 3A-C: verschiedene Zustände der Ansaugvorrichtung,
- Fig. 4: ein Detail der Ansaugvorrichtung, und
- Fig. 5: eine weitere Ansaugvorrichtung.

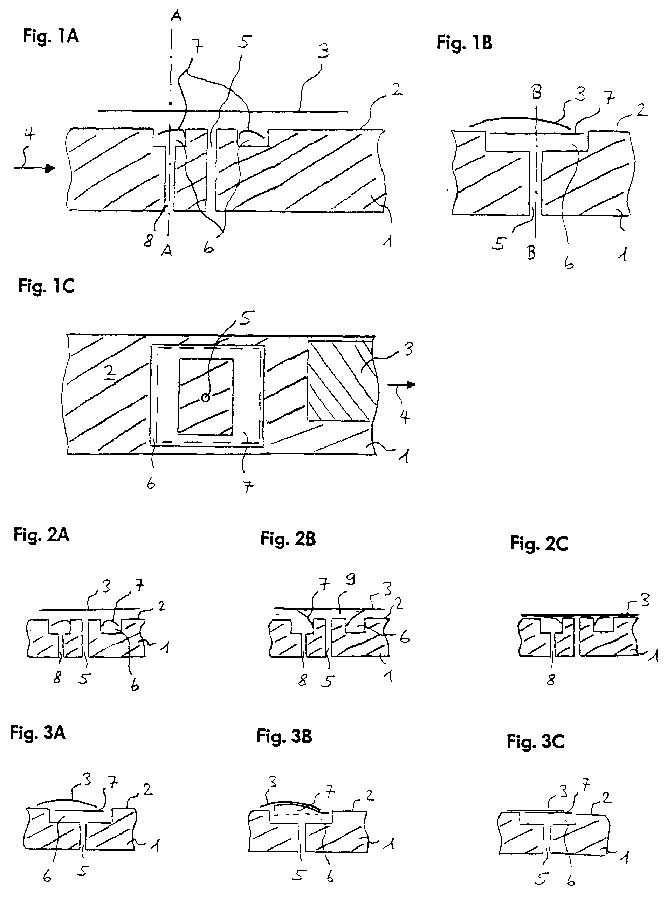

Die Fig. 1 A zeigt im Querschnitt eine Platte 1 mit einer glatten Auflagefläche 2 zur Aufnahme eines Substrates 3. Das Substrat 3 wird von einer nicht dargestellten Transporteinrichtung taktweise in einer Transportrichtung 4 zu einer Bondstation vorgeschoben, wo es entweder mit einem Halbleiterchip bestückt wird oder wo Drahtverbindungen zwischen einem montierten Halbleiterchip und dem Substrat 3 hergestellt werden. Die Platte 1 weist eine Bohrung 5 auf, die mit einer ein- und ausschaltbaren Vakuumquelle verbunden ist. Die Platte 1 enthält eine gegen die Auflagefläche 2 offene Kavität 6, die die Bohrung 5 umgibt. In der Kavität 6 befindet sich ein flexibles Dichtungselement 7, beispielsweise in Gestalt einer dünnen Membrane aus Gummi.

Die Fig. 1B zeigt die Platte 1 im Schnitt quer zur Transportrichtung entlang der Linie A-A der Fig. 1A. Die Linie B-B bezeichnet die Lage des in der Fig. 1A gezeigten Schnittes. Das Substrat 3 ist nach oben gewölbt. Die Wölbung des Substrates 3 in seiner Längsrichtung, die gleich der Transportrichtung 4 ist, ist geringer als seine Wölbung quer zur Transportrichtung 4 und nur in der Fig. 1B ersichtlich. In der Regel liegen die Längskanten des gewölbten Substrates 3 im Bereich der Ansaugvorrichtung auf der Platte 1 auf. Zudem ist es üblich, das Substrat 3 im Bereich seiner Längskanten mittels Rollen gegen die Platte 1 zu drücken.

Die Fig. IC zeigt die Platte 1 und das Substrat 3 in der Aufsicht. Die Ansaugvorrichtung ist für Substrate 3 unterschiedlicher Breite geeignet. Das Substrat 3 ist der Klarheit der Zeichnung wegen nicht über der Ansaugvorrichtung, sondern in Transportrichtung 4 neben der Ansaugvorrichtung eingezeichnet.

Das Dichtungselement 7 dient dazu, zwischen der Bohrung 5 und dem Substrat 3 einen mehr oder weniger gut abdichtenden Hohlraum zu bilden, damit das Substrat 3 bei Beaufschlagung des Hohlraumes mit Vakuum auf die Auflagefläche 2 gesogen wird, bis es flach auf der Auflagefläche 2 aufliegt. Damit das Dichtungselement 7 diese Aufgabe erfüllen kann, muss es sich der Wölbung des Substrates 3 anpassen können. Die Abdichtung des Hohlraumes kann, muss aber nicht vollständig sein. Zum Ansaugen des Substrates 3 genügt es, die Leckrate des Hohlraumes derart zu begrenzen, dass zwischen der Oberseite und der Unterseite des Substrates 3 eine Druckdifferenz aufgebaut werden kann, die ausreicht, um das Substrat 3 flach zu drücken.

Bei dem gezeigten Beispiel ist eine einzige Kavität 6 mit einem einzigen Dichtungselement 7 vorhanden. Es ist natürlich möglich, die Kavität 6, die in der Fig. 1A als zwei beidseitig der Bohrung 5 angeordnete Vertiefungen erscheint, in zwei getrennte Kavitäten aufzutrennen und beide Kavitäten mit je einem Dichtungselement 7 zu versehen.

Die Fig. 2A bis 2C und Fig. 3A bis 3C zeigen schematisch die Wirkungsweise dieser erfindungsgemässen Ansaugvorrichtung in den beiden Schnittrichtungen längs der Transportrichtung 4 bzw. quer zur Transportrichtung 4. Bei dem in den Fig. 2A und 3A gezeigten Zustand berührt das Dichtungselement 7 das Substrat 3 noch nicht: Der Raum zwischen der Bohrung 5 und dem Substrat 3 bildet keinen abgedichteten Hohlraum. Bei den Fig. 2B und 3B ist der Zustand dargestellt, bei dem das Dichtungselement 7 das Substrat 3 berührt: Zwischen der Bohrung 5 und dem Substrat 3 hat sich ein abgedichteter Hohlraum 9 gebildet. Die Fig. 2C und 3C zeigen den Zustand, bei dem die Bohrung 5 mit Vakuum beaufschlagt wird. Da der Hohlraum 9 genügend abdichtet, wird das Substrat 3 vom Atmosphärendruck gegen die Auflagefläche 2 gedrückt und liegt flach auf der Auflagefläche 2 auf. Jetzt kann der Bondvorgang erfolgen. Nach dem Lösen des Vakuums bildet sich wieder der in den Fig. 2A und 3A gezeigte Zustand aus und das Substrat 3 kann weiter transportiert werden.

Es werden nun zwei Ausführungsbeispiele näher erläutert:

### Beispiel 1

Die in der Fig. 1 gezeigte Ansaugvorrichtung ist besonders vorteilhaft. Die Kavität 6 steht über eine Bohrung 8 mit der Aussenwelt in Verbindung, so dass in ihr atmosphärischer Druck herrscht. Beim Anlegen von Vakuum an die Bohrung 5 bewirkt die Druckdifferenz zwischen dem Druck in der Kavität 6 (Atmosphärendruck) und der Bohrung 5 (Vakuum) einen Sog auf das Dichtungselement 7, so dass sich das Dichtungselement 7 biegt, bis es am gewölbten Substrat 3 anliegt. Das Dichtungselement 7 ist nämlich um ein Vielfaches elastischer als das vergleichsweise starre Substrat 3. Jetzt hat sich zwischen der Bohrung 5 und dem Substrat 3 der Hohlraum 9 (Fig. 2B) gebildet und es baut sich im Hohlraum 9 ein genügend grosser Unterdruck oder sogar Vakuum auf mit der Wirkung, dass das Substrat 3 von dem auf seiner Oberseite herrschenden Atmosphärendruck gegen die Auflagefläche 2 gedrückt wird.

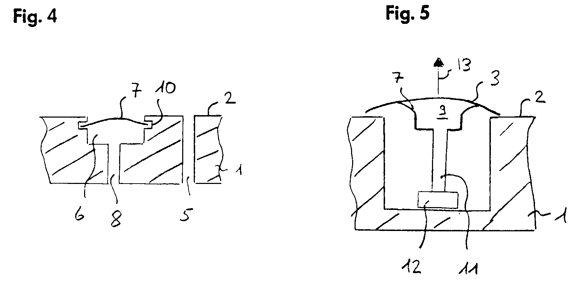

Damit das Dichtungselement 7 beim Transport des Substrates 3 nicht ungewollt mitgezerrt wird, ist die Kavität 6, wie in der Fig. 4 gezeigt ist, bevorzugt mit einer umlaufenden Nut 10 ausgebildet, in der das Dichtungselement 7 entweder lose eingelegt oder zumindest auf der der Bohrung 5 zugewandten Seite der Kavität 6 luftdicht befestigt ist. Sobald Vakuum an die Bohrung 5 angelegt wird, bewirkt der auf das Dichtungselement 7 einwirkende Sog eine Wölbung des Dichtungselementes 7, bis es das Substrat 3 berührt. Anstelle der Nut 10 kann auch ein Vorsprung vorgesehen sein, der das Dichtungselement 7 in seiner Kavität 6 hält.

Obwohl die Sogwirkung in der Regel ausreicht, könnte der Kavität 6 bei Bedarf über die Bohrung 8 Druckluft zugeführt werden, so dass sich das Dichtungselement 7 unter der Wirkung der Druckluft verbiegt und den Hohlraum 9 bildet. Der Druck der Druckluft muss dazu nur leicht über dem Atmosphärendruck liegen.

### Beispiel 2

Die Fig. 5 zeigt eine weitere Ansaugvorrichtung, bei der ein kreisrundes Dichtungselement 7 vorgesehen ist, das über eine Bohrung 11 mit Vakuum beaufschlagt werden kann. Das Dichtungselement 7 ist mittels eines elektrischen oder pneumatischen Antriebes 12 in vertikaler Richtung 13 von einer abgesen eine angehobene Position, typisch um etwa 2 mm, verschiebbar. Der Antrieb 12 dient dazu, das Dichtungselement 7 in Berührung mit dem noch gewölbten Substrat 3 zu bringen. Der Rand des Dichtungselementes 7, der jeweils mit dem Substrat 3 in Berührung kommt, ist dabei elastisch ausgestaltet, damit sich das Dichtungselement 7 beim Anfahren der angehobenen Position der Wölbung des Substrates 3 anpassen und den abdichtenden Hohlraum 9 bilden kann und damit anschliessend das Substrat 3, wenn es gegen die Platte 1 gesogen wird, den Rand des Dichtungselementes 7 problemlos verbiegen kann. Das Substrat 3 kommt somit flach auf der Auflagefläche 2 der Platte 1 zur Auflage, sobald Vakuum an die Bohrung 11 gelegt wird, selbst wenn der Antrieb das Dichtungselement 7 noch in der angehobenen Position hält. Das Dichtungselement 7 wird dann vor oder nach dem Bondvorgang wieder abgesenkt. Bei einer anderen Lösung ist das Dichtungselement 7 federnd am Antrieb 12 gelagert, so dass das angesogene Substrat 3 das Dichtungselement 7 gegen den Antrieb 12 einfedern kann.

## Patentansprüche

1. Ansaugvorrichtung zum Niederhalten eines mit Halbleiterchips zu bestückenden oder bestückten Substrates (3) auf einer Auflagefläche (2) einer Platte (1), die eine mit einer Vakuumquelle verbindbare Bohrung (5) zum Ansaugen des Substrates (3) aufweist, **dadurch gekennzeichnet,** dass die Platte (1) eine gegen die Auflagefläche (2) offene Kavität (6) enthält und dass die Kavität (6) ein Dichtungselement (7) zur Bildung eines Hohlraumes (9) zwischen dem Substrat (3) und der Bohrung (5) aufweist.

2. Ansaugvorrichtung nach Anspruch 1, **dadurch gekennzeichnet**, dass die Kavität (6) druckmässig mit der Aussenwelt in Verbindung steht.

3. Ansaugvorrichtung nach Anspruch 1 oder 2, **dadurch gekennzeichnet**, dass das Dichtungselement (7) mittels eines Antriebes heb- und senkbar ist.
